Europäisches Patentamt

(19) European Patent Office

Office européen des brevets

(11) EP 0 735 592 A2

(12) EUROPEAN PATENT APPLICATION

(43) Date of publication:
02.10.1996 Bulletin 1996/40

(51) Int. Cl.$^6$: H01L 29/786

(21) Application number: 96105132.3

(22) Date of filing: 29.03.1996

(84) Designated Contracting States:
DE FR GB

(30) Priority: 31.03.1995 JP 75229/95
04.12.1995 JP 315197/95

(71) Applicant: NIPPON TELEGRAPH AND
TELEPHONE CORPORATION
Shinjuku-ku, Tokyo 163-19 (JP)

(72) Inventors:
• Ohno, Terukazu
Isehara-shi, Kanagawa (JP)
• Takahashi, Mitsutoshi
Hiratsuka-shi, Kanagawa (JP)
• Tsuchiya, Toshiaki
Yokohama-shi, Kanagawa (JP)

(74) Representative: Haft, Uwe Michael, Dipl.-Phys. et
al
Patentanwälte
Haft, von Puttkamer
Berngruber, Czybulka
Franziskanerstrasse 38
81669 München (DE)

(54) MOS thin film transistor and method of fabricating the same

(57) A MOS transistor includes a body region of a first conductivity type, a source region and a drain region of a second conductivity type, a gate electrode, and a minority carrier recombination region. The body region is formed on a buried insulating film and made from a crystalline semiconductor. The source and drain regions are formed on the buried insulating film so as to sandwich the body region and made from a crystalline semiconductor. The gate electrode is formed on the body region via a gate oxide film. The minority carrier recombination region is formed, in contact with the buried oxide film, in the source region from a position a predetermined distance from the body region, and consists of crystal defects. A method of fabricating this MOS transistor also is disclosed.

FIG.1

EP 0 735 592 A2

**Description**

Background of the Invention

The present invention relates to a high-packing-density, high-speed MOS transistor formed on an SOI (Silicon On Insulator) substrate and a method of fabricating the same.

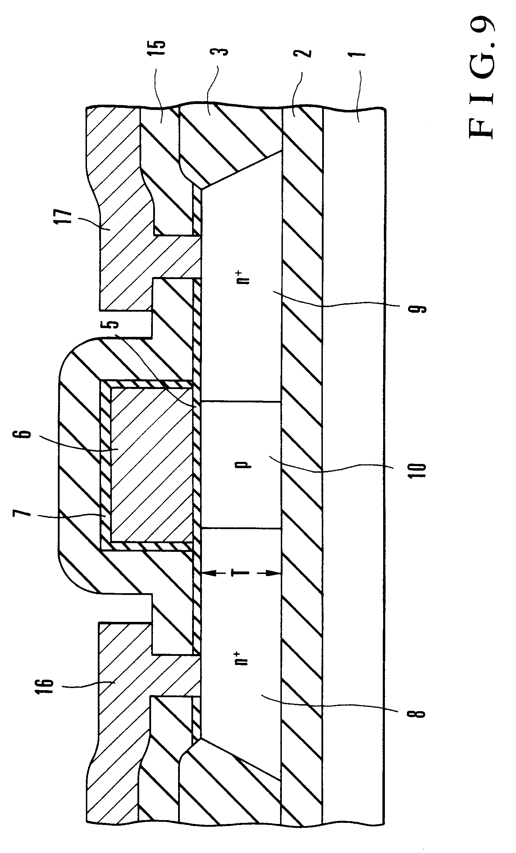

Fig. 9 is a sectional view showing the structure of a conventional n-channel MOS transistor formed on an SOI substrate. In Fig. 9, reference numeral 1 denotes a crystalline silicon substrate; 2, a silicon oxide film as a buried insulating layer; 3, a silicon oxide film for device isolation in the lateral direction; 5, a gate silicon oxide film; 6, a gate electrode made from n-type polycrystalline silicon; 7, a silicon oxide film for protecting the surface of the gate electrode 6; 8, an n-type source region; 9, an n-type drain region; 10, a p-type body region; 15, a PSG film as a passivation film; 16, a source electrode; and 17, a drain electrode.

This n-channel MOS transistor with the above structure is completely covered with the insulating films 2 and 3. Therefore, even when a CMOS structure is fabricated by forming this n-channel MOS transistor and a p-channel MOS transistor on the same substrate, no latch-up occurs in principle, and so a high packing density can be obtained.

Also, the bottom surfaces of the source region 8 and the drain region 9 are in contact with the silicon oxide film 2. Accordingly, by increasing the thickness of this silicon oxide film 2 it is possible to greatly reduce the parasitic capacitance formed between the crystalline silicon substrate 1 and these two regions 8 and 9. As a consequence, a high-speed operation can be realized.

Furthermore, the work functions of the gate electrode 6 and the body region 10 are different from each other. Therefore, by designing a thickness T of the body region 10 to be smaller than the thickness of a depletion layer induced in the body region 10, the overall body region 10 can be fully depleted even if this n-channel MOS transistor is OFF.

Consequently, it is possible to reduce variations in the device characteristics caused by short-channel effects resulting from miniaturization of devices and to achieve a high operating speed due to an increase in the drain current.

As described above, a MOS transistor formed on an SOI substrate can achieve both a high packing density and a high operating speed and hence is expected to be promising as components for constituting ULSI circuits in the future.

Note that the details of the characteristics herein mentioned are disclosed in known literature (e.g., J. P. Colinge, "SOI technology for deep-submicron CMOS application, "Proceedings of the Fourth International Symposium on Ultra Large Scale Integration Science and Technology, Electrochemical Society, Vol. 93-13, pp. 39-54, 1993.)

In the conventional n-channel MOS transistor described above, the body region 10 is normally used in a floating state; it is very unusual to form a dedicated electrode in the body region 10 and externally, forcedly apply a desired potential.

This is because if a dedicated electrode is formed in the body region 10, the area occupied by the n-channel MOS transistor necessarily increases, and this largely impairs the advantage of a high-packing density mentioned above.

If the body region 10 is used in a floating state, however, the following problems arise in the electrical characteristics.

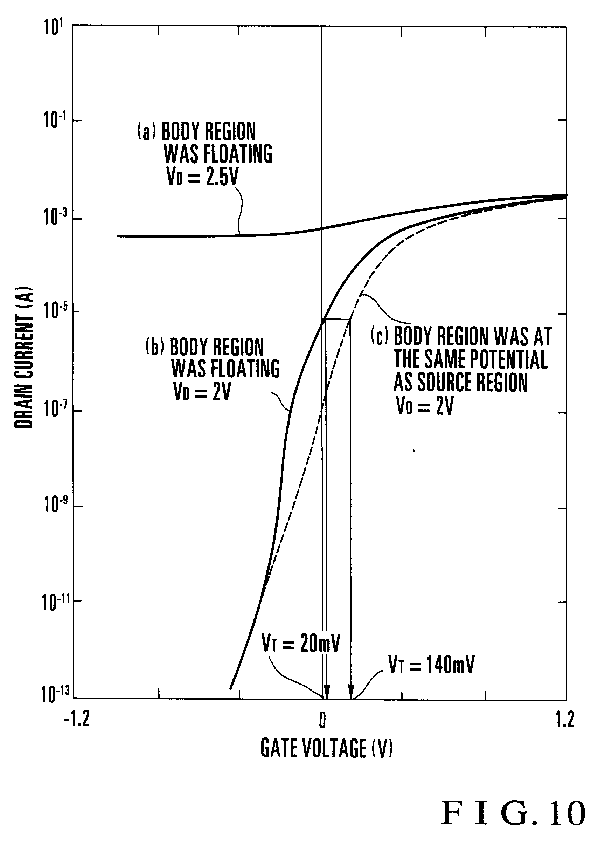

Fig. 10 is a graph showing typical relationships between the drain current and the gate voltage in an n-channel MOS transistor formed on an SOI substrate.

In this MOS transistor, the length of the gate electrode 6 is 0.24 $\mu$m and its width is 10 $\mu$m. The thickness T of the body region 10 is 50 nm. This MOS transistor is so designed that the overall body region 10 is depleted when the gate voltage is OFF.

Referring to Fig. 10, characteristic curves (a) and (b) indicated by the solid lines were obtained when drain voltages $V_D$, respectively, of 2 V and 2.5 V were applied while the body region 10 was in a floating state. A characteristic curve (c) indicated by the broken line was obtained when the source electrode 16 was also used as a dedicated electrode for the body region 10 and a drain voltage $V_D$ of 2 V was applied while the body region 10 was forcedly fixed to the source potential.

Comparing the characteristic curve (a) with the characteristic curve (c) when the drain voltage $V_D$ was 2 V shows that the drain current indicated by the characteristic curve (a) is much larger than that indicated by the characteristic curve (c). This is considered to be attributed to generation of a current by some parasitic device in the floating state.

Consequently, a threshold voltage $V_T$ obtained from the characteristic curve (a) is as low as 20 mV.

Since the threshold voltage $V_T$ is 140 mV on the characteristic curve (c) obtained when the body region 10 was fixed to the source potential, it is seen that the threshold voltage $V_T$ decreased by 120 mV because the body region 10 was in a floating state.

Also, floating the body region 10 resulted in an approximately order of magnitude higher drain current when the gate voltage was 0 V, i.e., in an OFF current.

Furthermore, the characteristic curve (c) when the drain current $V_D$ was increased to 2.5 V indicates the worst state in which a large drain current kept flowing even upon application of a negative bias as the gate voltage and so the n-channel MOS transistor could not be turned off only by controlling the gate voltage.

This state is a self-latch state which cannot be released unless the drain voltage $V_D$ is decreased.

This problem is considered to be caused by the action of a parasitic bipolar transistor in which the n-type source region 8, p-type body region 10, and the n-type drain region 9 serve as an emitter region, a base region, and a collector region, respectively.

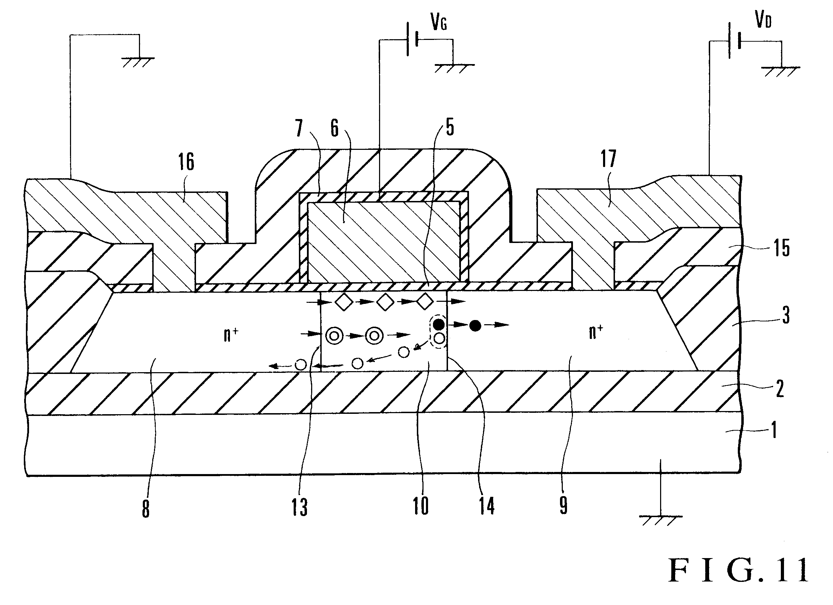

This will be described in detail below from the viewpoint of the behavior of carriers in an n-channel MOS transistor illustrated in Fig. 11.

To operate the n-channel MOS transistor shown in Fig. 11, a crystalline silicon substrate 1 and a source electrode 16 are grounded, and a positive drain voltage $V_D$ and a positive gate voltage $V_G$ are applied to a drain electrode 17 and a gate electrode 6, respectively.

When the drain voltage $V_D$ is raised, electron-hole pairs (o and ● enclosed by the dotted line in Fig. 11) are generated by impact ionization in a high-field depletion layer formed in a drain/body metallurgical junction 14.

Of the generated electron-hole pairs, the electrons (● in Fig. 11) flow into a drain region 9, and the holes (o in Fig. 11) flow into a body region 10.

The holes flow toward a source region 8 along the bottom surface of the body region 10 with a low potential. A current (Ip) caused by these holes functions as the base current of a parasitic bipolar transistor.

The holes reaching a source/body metallurgical junction 13 are injected into the source region 8 through this junction, recombine with electrons which are majority carriers in this region, and disappear.

At the same time these holes are injected electrons are reversely injected from the source region 8 into the body region 10.

An electron current (In) caused by these inversely injected electrons ( ◎ in Fig. 11) is the emitter current of the parasitic bipolar transistor. This electron current (In) joins an inherent channel current of the MOS transistor which consists of electrons (◊ in Fig. 11) induced on the upper surface of the body region 10 by the gate voltage.

If the drain voltage $V_D$ is further raised, the number of electron-hole pairs generated in the drain depletion layer increases, and this increases the hole current (Ip) and consequently the electron current (In).

The increased electron current (In) encourages the impact ionization in the depletion layer formed in the drain/body metallurgical junction, generating a still larger number of electron-hole pairs.

This positive feedback state corresponds to the characteristic curve (b) in Fig. 10.

Note that fixing the body region 10 to the source potential described earlier amounts to extracting the hole current (Ip) from the body region 10 without the intermediacy of the source/body metallurgical junction 13, and so no electron current (In) is generated in this case.

That is, the parasitic bipolar transistor is not turned on. This state corresponds to the characteristic curve (c) in Fig. 10.

Accordingly, to suppress the action of the parasitic bipolar transistor with the floating body region 10, it is necessary to minimize the electron current (In) reversely injected from the source region 8 into the body region 10.

As described above, a MOS transistor formed on an SOI substrate has excellent characteristics, i.e., can achieve a high packing density and a high operating speed. However, this MOS transistor also has problems derived from the use of the body region 10 in a floating state, i.e., problems of an increase in the OFF current and a decrease in the threshold voltage. Therefore, this MOS transistor has not been put into practical use yet.

Summary of the Invention

The present invention has been made to solve the above conventional problems and has as its object to provide a MOS transistor capable of suppressing the action of a parasitic bipolar transistor even when a body region is used in a floating state and thereby achieving both a high packing density and a high operating speed, and a method of fabricating the same.

To achieve the above object, in a MOS transistor according to the present invention, a minority carrier recombination region consisting of crystal defects is formed, in contact with a buried insulating film, from a position a predetermined distance from a body region, in a source region formed on the buried insulating film and made from a crystalline semiconductor.

Of electron-hole pairs generated in the junction between the body region and the drain region, carriers of a first conductivity type are injected into the source region through the body region. These carriers recombine in the minority carrier recombination region and disappear.

In a MOS transistor fabrication method according to the present invention, a rare gas element is ion-implanted to form a minority carrier recombination region consisting of crystal defects, in contact with a buried insulating film, from a position a predetermined distance from a body region, in a source region formed on the buried insulating film and made from a crystalline semiconductor.

The ion-implanted rare gas element forms crystal defects in the crystalline semiconductor source region but does not function as carriers.

Brief Description of the Drawings

Fig. 1 is a sectional view of an n-channel MOS transistor showing the structure of an embodiment of a MOS transistor according to the present invention;

Fig. 2 is a sectional view for explaining an initial step of an embodiment of a MOS transistor fabrication method according to the present invention;

Fig. 3 is a sectional view of a step subsequent to Fig. 2;

Fig. 4 is a sectional view of a step subsequent to Fig. 3;

Fig. 5 is a sectional view of a step subsequent to Fig. 4;

Fig. 6 is a graph showing the distribution of the electron concentration in the direction of depth in a source region formed by the embodiment of the MOS transistor fabrication method according to the present invention;

Fig. 7 is a graph showing the threshold voltage of an n-channel MOS transistor formed by the embodiment of the MOS transistor fabrication method according to the present invention;

Figs. 8A and 8B are plan views showing the distributions of minority carrier recombination regions;

Fig. 9 is a sectional view showing the structure of a conventional n-channel MOS transistor;

Fig. 10 is a view showing the relationships between the drain current and the gate voltage of the conventional n-channel MOS transistor; and

Fig. 11 is a sectional view for explaining a parasitic bipolar transistor effect appeared in the conventional n-channel MOS transistor.

Description of the Preferred Embodiments

Embodiments of the present invention will be described in detail below with reference to the accompanying drawings.

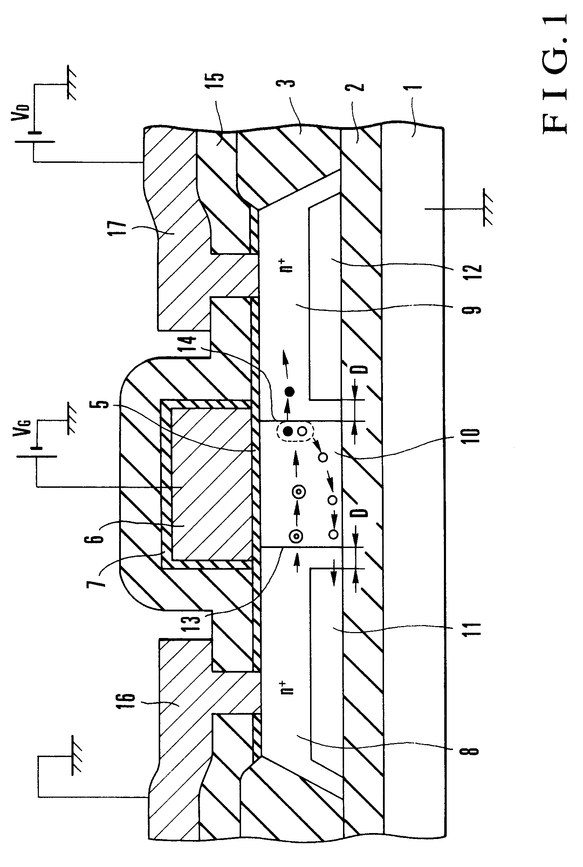

Fig. 1 is a sectional view of an n-channel MOS transistor showing the structure of an embodiment of a MOS transistor according to the present invention.

In Fig. 1, reference numeral 1 denotes a crystalline silicon substrate; and 2 and 3, silicon oxide films for device isolation. The silicon oxide film 2 is a buried insulating film on an SOI substrate.

Reference numeral 5 denotes a gate silicon oxide film; 6, an n-type polycrystalline silicon gate electrode; and 7, a silicon oxide film for protecting the surface of the gate electrode 6.

Reference numeral 8 denotes an n-type crystalline silicon source region formed on the silicon oxide film 2; 9, an n-type crystalline silicon drain region formed on the silicon oxide film 2; and 10, a p-type crystalline silicon body region formed between the source region 8 and the drain region 9 on the silicon oxide film 2.

Reference numeral 11 denotes an n-type minority carrier recombination region formed in the source region 8; and 12, an n-type minority carrier recombination region formed in the drain region 9.

Reference numeral 13 denotes a metallurgical junction between the source region 8 and the body region 10, i.e., a source/body metallurgical junction; 14, a metallurgical junction between the drain region 9 and the body region 10, i.e., a drain/body metallurgical junction; 15, a PSG film as a passivation film; 16, a source electrode; and 17, a drain electrode.

In this structure, the minority carrier recombination region 11 is a region in which crystal defects are formed, and is formed, in contact with the silicon oxide film 2, in the source region 8 from a position a distance D from the source/body metallurgical junction 13. Analogously, the minority carrier recombination region 12 is formed, in contact with the silicon oxide film 2, in the drain region 9 from a position the distance D from the drain/body metallurgical junction 14.

These minority carrier recombination regions 11 and 12 are arranged so as not to contact a depletion layer from the body region 10. Essentially, the minority carrier recombination regions 11 and 12 are arranged so as not to contact the body region 10.

When the minority carrier recombination regions are thus formed apart from the metallurgical junctions, these regions do not come in contact with the respective metallurgical junctions, and this prevents an increase in the respective junction leakage currents.

In pn junction theories, a width W1 of a depletion layer extending from a metallurgical junction toward an n-type drain region and a width W2 of a depletion layer extending from a metallurgical junction toward a p-type body region are represented by the following equations:

$$W1 = [\{2 \cdot \varepsilon \cdot Na \cdot (Vbi + Vd)\}/\{q \cdot Nd \cdot (Na + Nd)\}]^{1/2}$$

$$W2 = [\{2 \cdot \varepsilon \cdot Nd \cdot (Vbi + Vd)\}/\{q \cdot Na \cdot (Na + Nd)\}]^{1/2}$$

EP 0 735 592 A2

where $\varepsilon$ is the dielectric constant of silicon, q is the charge amount of an electron, Vbi is the built-in potential, Vd is the drain voltage, Na is the impurity concentration in the p-type body region, and Nd is the impurity concentration in the n-type source region.

If Na = 3 x $10^{17}$ cm$^{-3}$, Nd = 2 x $10^{20}$ cm$^{-3}$, q = 1.6 x $10^{-19}$ C, Vbi = 1 V, and Vd = 2 V, W1 = 0.17 nm and W2 = 113.6 nm.

That is, the width of the depletion layer extending from the metallurgical junction toward the drain is very small, 0.2 nm or less, and is therefore negligible in practice.

Accordingly, as described above, it is essentially only necessary to arrange the minority carrier recombination regions 11 and 12 so that these regions do not contact the body region 10.

Note that the thickness of the body region 10 is set to be smaller than the thickness of a depletion layer which can extend from immediately below the gate silicon oxide film 5.

In an n-channel MOS transistor having the above structure, the action of a parasitic bipolar transistor can be suppressed by setting the distance D to be smaller than the diffusion length of holes in the source region 8. This will be described below.

To drive this n-channel MOS transistor, the crystalline substrate 1 and the source electrode 16 are grounded, and appropriate positive gate and drain voltages $V_G$ and $V_D$ are applied to the gate and drain electrodes 6 and 17, respectively.

For example, when the drain voltage $V_D$ is raised to 2 V, a high electric field is generated near the drain/body metallurgical junction 14 as in conventional n-channel MOS transistors. As a result, electron-hole pairs (o and ● enclosed by the broken line in Fig. 1) are generated by impact ionization.

The holes (o in Fig. 1) flow into the body region 10.

Although some holes disappear by recombination or are accumulated in the body region 10, most holes flow into the source region 8 through the body region 10.

Since the minority carrier recombination region 11 is located at the distance D from the source/body metallurgical junction 13, the holes injected into the source region 8 are forced to recombine with electrons, as majority carriers, by crystal defects in the minority carrier recombination region 11 and vanish.

Consequently, the diffusion length of holes in the source region 8 is essentially the distance D.

As described previously in "Background of the Invention", to suppress a parasitic bipolar transistor it is important to minimize the number of electrons ( ◎ in Fig. 1) reversely injected from the source region 8 into the body region 10 through the source/body metallurgical junction 13.

According to bipolar transistor theories handling a steady state, it is known that the ratio of an electron current (In) injected from the source region 8 into the body region 10 to a hole current (Ip) flowing from the body region 10 into the source region 8 is given by the following approximation:

$$\text{In/Ip} = (\text{LpE} \cdot \sigma\text{E})/\{\text{LnB} \cdot \sigma\text{B} \cdot \tanh(\text{Leff/LnB})\}$$

where LpE is the diffusion length of holes in the n-type source region 8 acting as an emitter, $\sigma$E is the conductivity of the source region 8, LnB is the diffusion length of electrons in the p-type body region 10 acting as a base, $\sigma$B is the conductivity of the body region 10, and Leff is the length of the body region 10, i.e., the effective channel length of the MOS transistor.

The above approximation shows that decreasing the diffusion length LpE of holes is possible as a method of efficiently reducing the electron current (In) without changing the structural parameter and the various electrical characteristics of the body region 10.

Assume that the diffusion length of holes in a MOS transistor with a conventional structure not having the minority carrier recombination region 11 in the source region 8 is LpE. In the MOS transistor structure of the present invention, if the minority carrier recombination region 11 is so arranged that the distance D is smaller than LpE, the number of electrons injected from the source region 8 into the body region 10 is decreased in accordance with the above approximation.

As a consequence, the action of a parasitic bipolar transistor is suppressed.

As described above, the minority carrier recombination region 11 formed in the source region 8 plays an important role is suppressing a parasitic bipolar transistor. Similar effects can be obtained by the minority carrier recombination region 12 formed in the drain region 9.

In common MOS transistors, the source and drain regions 8 and 9 have the same structure and are distinguished from each other by the magnitudes of the applied voltages.

In n-channel MOS transistors, for example, the low-voltage side is called a source region and the high-voltage side is called a drain region.

Assuming a MOS transistor is incorporated into an actual integrated circuit such as a transmission gate circuit, the magnitudes of voltages applied to the source and drain regions change with time and consequently the source and drain regions sometimes interchange with passing of time.

5

To realize a structure of a MOS transistor from which the effect of this embodiment can be expected even in this case, the minority carrier recombination region 12 must be formed in the drain region 9.

In the above embodiment, minority carrier recombination regions are formed in an n-channel MOS transistor. However, analogous effects can be obtained in a p-channel MOS transistor by forming minority carrier recombination regions in the source and drain regions, since n- and p-channel MOS transistors are different only in the conductivity types of the source, drain, and body regions and the gate electrode.

Also, similar effects can be obtained in a complementary type MOS transistor structure in which n- and p-channel MOS transistors are formed on the same SOI substrate.

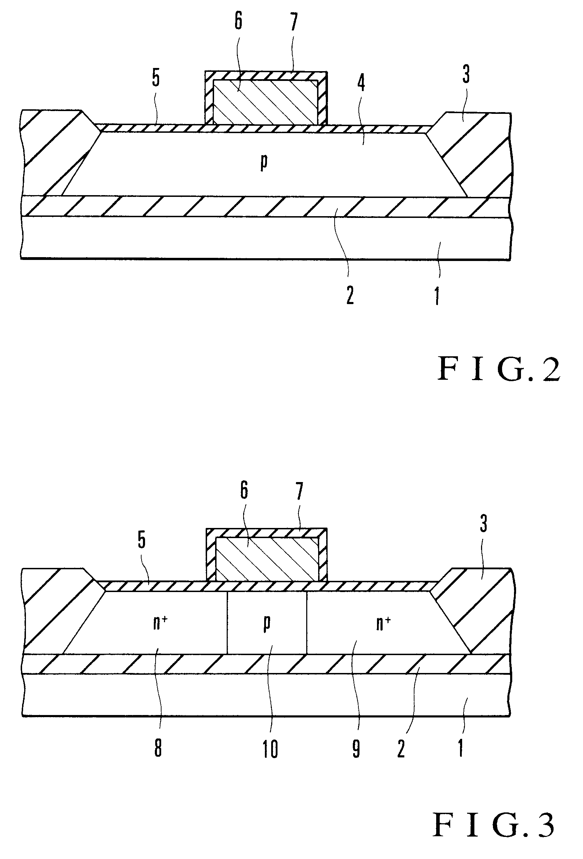

Figs. 2 to 5 are sectional views for explaining an embodiment of a method of fabricating the n-channel MOS transistor shown in Fig. 1, in which individual fabrication steps are illustrated.

The MOS transistor in Fig. 1 is formed on an SOI substrate on which a crystalline silicon substrate 1, a silicon oxide film 2 with a thickness of about 90 nm, and a crystalline silicon layer with a thickness of about 50 nm are stacked in this order.

Note that the SOI substrate used as a starting substrate can be formed by any of a deposition film recrystallization method, a crystal separation method, a heteroepitaxial deposition method, and a bonding method.

By using this SOI substrate as a starting substrate, a silicon oxide film 3 for lateral device isolation is formed by selective oxidation, thereby forming a crystalline silicon island 4 surrounded by the silicon oxide films 2 and 3.

Thereafter, boron ions are implanted into the crystalline silicon island 4 to give the crystalline silicon island 4 a desired p-type impurity concentration. Subsequently, the surface of the crystalline silicon island 4 is thermally oxidized to form a gate silicon oxide film 5 about 5 nm thick.

A phosphorus-doped polycrystalline silicon film about 300 nm thick is deposited on the gate silicon oxide film 5 by low-pressure chemical vapor deposition. This phosphorus-doped polycrystalline silicon film is etched into a gate electrode 6 by using a resist as a mask. After the resist is removed, the surface of the gate oxide film 6 is thermally oxidized to form a silicon oxide film 7 about 10 nm thick (Fig. 2).

As shown in Fig. 3, phosphorus ions are implanted by using the stacked film consisting of the gate electrode 6 and the silicon oxide film 7 as a mask and annealing is performed, thereby simultaneously forming an n-type source region 8 and an n-type drain region 9.

A p-type crystalline silicon region sandwiched between the source region 8 and the drain region 9 is a body region 10.

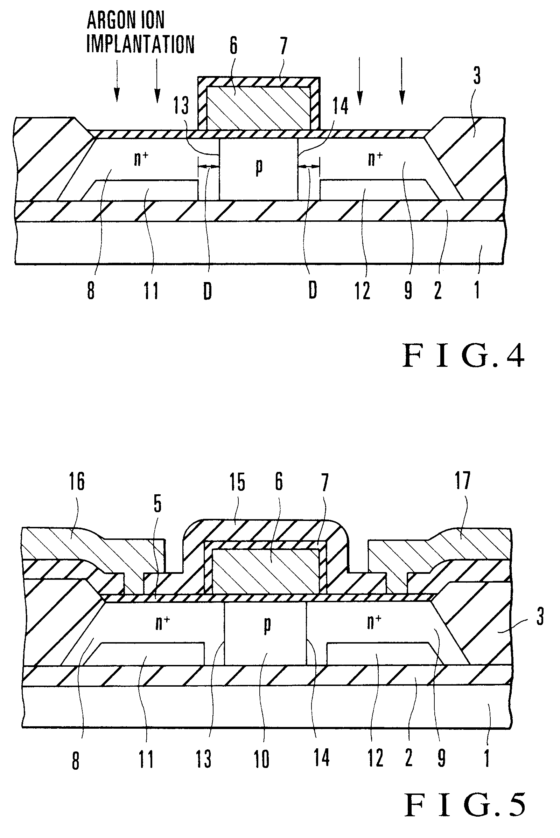

As illustrated in Fig. 4, argon ions, for example, are implanted with an acceleration energy of 50 keV, a does of 1 x $10^{14}$ $cm^{-2}$, and a beam incident angle of 7° into the source region 8 and the drain region 9 by using the stacked film consisting of the gate electrode 6 and the silicon oxide film 7 as a mask.

With this acceleration energy the projected range of argon is approximately 50 nm in the vertical direction. Accordingly, immediately after the ion implantation the position at which the concentration of argon is a maximum is near the interface between the source region 8 or the drain region 9 and the silicon oxide film 2.

Thereafter, annealing is performed at 950°C for 15 sec.

Consequently, an n-type minority carrier recombination region 11 and an n-type minority carrier recombination region 12 both containing a number of crystal defects are simultaneously formed in the source region 8 and the drain region 9, respectively, at positions adjacent to the silicon oxide film 2.

Reference symbol D in Fig. 4 denotes the distance from a source/body metallurgical junction 13 to the minority carrier recombination region 11 or the distance from a drain/body metallurgical junction 14 to the minority carrier recombination region 12.

The distance D can be estimated to be approximately 25 nm when the following three points are taken into consideration: the source/body metallurgical junction 13 and the drain/body metallurgical junction 14 invade a distance of about 40 nm from the edge of the gate electrode 6; the thickness of the silicon oxide film 7 is about 10 nm; and the lateral standard deviation of argon is about 25 nm.

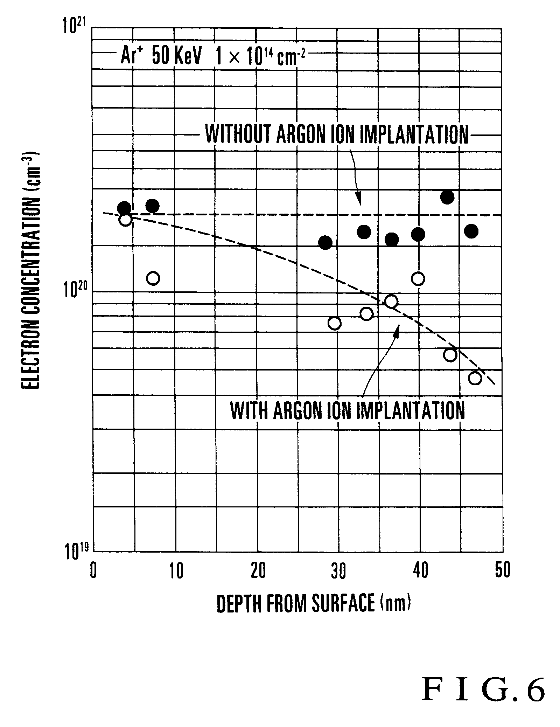

As shown in Fig. 5, a PSG film 15 is deposited as a passivation film, and electrode contacts are opened to form a source electrode 16 and a drain electrode 17. Finally, hydrogen annealing is performed to complete the SOI type n-channel MOS transistor illustrated in Fig. 1.

In this embodiment, the beam incident angle is set at 7° as the argon ion implantation condition. However, if an oblique ion implantation method in which the beam incident angle is further increased is used, the distance D can be further decreased without adding any new fabrication step.

In an extreme case, the distance D can be decreased to 0 if the beam incident angle is 45°.

Apart from this extreme case, the distance D can be set at a desired small value with a high controllability by a self-aligned technique which uses the argon ion implantation condition as a parameter.

Fig. 6 shows the distribution of the electron concentration (o in Fig. 6) in the direction of depth in the n-type source region 8 when argon ions were implanted at a dose of 1 x $10^{14}$ $cm^{-2}$ in accordance with the embodiment of the fabrication method described above.

Fig. 6 also shows the distribution of the electron concentration (● in Fig. 6) measured in a control sample when no argon ions were implanted.

In the control sample, the electron concentration was nearly constant at approximately $2 \times 10^{20}$ cm$^{-3}$ in the direction of depth.

When argon ions were implanted, on the other hand, the electron concentration was the same as in the control sample near the surface but gradually decreased as the measurement position became deeper from the surface. When the depth was about 50 nm which was near the interface between the source region 8 and the silicon oxide film 2, the electron concentration was approximately $4 \times 10^{19}$ cm$^{-3}$, about 1/5 that on the surface.

It is hypothesized that crystal defects were induced in the source region 8 by the ion implantation of argon, these crystal defects formed deep levels in the bandgap, and consequently a large number of electrons were captured in these levels.

These deep levels act as recombination centers for holes as minority carriers.

Assuming that a region in which the electron concentration decreases to no more than one-half that near the surface, i.e., a region containing $1 \times 10^{20}$ cm$^{-3}$ or more of recombination centers is the minority carrier recombination region 11, it is evident from Fig. 6 that this recombination region is formed at a depth of 35 to 50 nm from the surface.

In the embodiment of the fabrication method described previously, therefore, it is assumed that a minority carrier recombination region 11 containing $1 \times 10^{20}$ cm$^{-3}$ or more of recombination centers and having a thickness of about 15 nm is formed in contact with the silicon oxide film 2 at a position separated by approximately 25 nm from the source/body metallurgical junction 13.

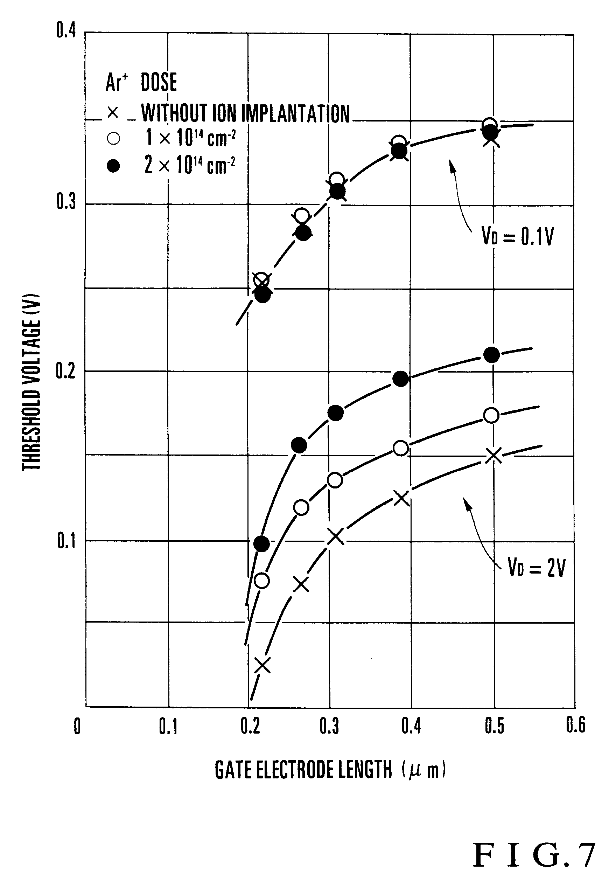

Fig. 7 is a graph showing the results which establish, from the viewpoint of the threshold voltage, the fact that a minority carrier recombination region formed by ion implantation of argon is effective to control a parasitic bipolar transistor.

The threshold voltage was measured by using the n-channel MOS transistor fabricated by the above embodiment. Also, in the fabrication of the transistor the dose of argon was used as a parameter.

Referring to Fig. 7, when the drain voltage $V_D$ was very low, 0.1 V, the number of electron-hole pairs generated in a depletion layer in the drain/body metallurgical junction was small, and the presence of a parasitic bipolar transistor was negligible.

Accordingly, the threshold voltage was independent of the dose of argon.

The threshold voltage decreased as the length of the gate electrode decreased. This is an inherent phenomenon called a short-channel effect of a MOS transistor.

On the other hand, when the drain voltage $V_D$ was high, 2 V, the number of electron-hole pairs generated in the depletion layer increased, and the current generated by the parasitic bipolar transistor became nonnegligible compared to the intrinsic channel current of the MOS transistor. This poses a problem of a reduction in the threshold voltage.

In Fig. 7, symbols x when no argon ions were implanted correspond to this state.

In contrast, when argon ion implantation was performed the threshold voltage obviously increased.

Also, the effect of increasing the threshold voltage was enhanced when the dose was increased from $1 \times 10^{14}$ cm$^{-2}$ (o in Fig. 7) to $2 \times 10^{14}$ cm$^{-2}$ (● in Fig. 7).

This demonstrates that a recombination region formed with a higher dose is more effective to decrease the current generated by a parasitic bipolar transistor.

In any case, Fig. 7 shows that the formation of a minority carrier recombination region is an effective means of suppressing the parasitic bipolar transistor effect.

Japanese Patent Laid-Open No. 7-193248 has disclosed a method by which a minority carrier recombination region is formed by ion implantation of any of silicon, oxygen, carbon, and nitrogen.

Argon used in this embodiment is superior to any of these elements for the reasons explained below.

First, when crystal defects are formed by ion implantation of silicon, these crystal defects vanish by solid-phase epitaxy if annealing is performed at a temperature higher than 600°C after the ion implantation.

That is, if this element is used, the temperature of the processing done after the ion implantation is limited to those lower than 600°C.

On the other hand, when argon is used as in this embodiment, crystal defects do not disappear even if annealing is performed at 950°C.

Consequently, no limitations are imposed on high-temperature processing during the device fabrication, e.g., a high-temperature insulating film formation step.

Formation of crystal defects using oxygen atoms requires a special ion implantation apparatus; i.e., no versatile apparatus can readily perform oxygen ion implantation.

That is, versatile ion implantation apparatuses use filament type ion sources. When oxygen is used, the filament burns to extremely decrease its life.

Additionally, since the mass number of oxygen is 16 which is smaller than 40 of argon, a dose of a $10^{16}$ cm$^{-2}$ order is necessary to form crystal defects. This value is two orders of magnitude larger than a $10^{14}$ cm$^{-2}$ order required when argon is used.

Consequently, the injection time is prolonged.

The mass number of carbon is 12, further smaller than that of oxygen. Therefore, a high dose of a $10^{16}$ cm$^{-2}$ order is required to form crystal defects, resulting in a long processing time.

In addition, carbon ions are implanted into a gate oxide film during the ion implantation.

It is reported that if this is the case, carbon in the gate oxide film reacts with hydrogen to generate a positive charge (open literature: Vivek Jain et al., "Internal Passivation for Suppression of Device Instabilities Induced by Backend Process." IEEE International Reliability Physics Symposium. pp. 11-15, 1992). This may cause a problem in the reliability.

The mass number of nitrogen also is small, 14, like those of oxygen and carbon, and so a high dose is required.

Additionally, it is known that nitrogen acts as a donor type impurity. Therefore, when nitrogen ions are implanted into the source region of a p-channel MOS transistor, the implanted nitrogen ions and the previously doped acceptor type impurity cancel each other out, and this may extraordinarily raise the sheet resistance of the source region.

Furthermore, in an n-channel MOS transistor the channel region has a low p-type impurity concentration. Accordingly, if implanted nitrogen ions are mixed in the channel region around the source region (or the drain region), the conductivity type may change in a portion of the channel region.

As described above, argon used in this embodiment has the characteristics explained below which none of the various elements described in Japanese Patent Laid-Open No. 7-193248 cited above has.

That is, argon can form crystal defects that are stable even when high-temperature annealing is performed. Since the mass number of argon is as large as 40, crystal defects can be efficiently formed with a relatively low dose. Argon ions can be implanted by using a general-purpose ion implantation apparatus. Argon acts as neither a donor nor acceptor type impurity.

Japanese Patent Laid-Open No. 7-15015 has disclosed a method of controlling the action of a parasitic bipolar transistor by implanting neutral impurity ions, such as ions of krypton, xenon, germanium, or argon, into a high-field region in a drain/body metallurgical junction.

The basis of this method is to decrease the mean free path of carriers by producing scattering centers in the high-field region by using the neutral impurity, thereby decreasing the number of electron-hole pairs generated by impact ionization near the drain/body metallurgical junction.

Accordingly, a region into which the neutral impurity is ion-implanted is necessarily close to the drain/body metallurgical junction and also close to the surface of a body region into which a channel current flows.

On the other hand, the basis of this embodiment is to form recombination centers near the source/body metallurgical junction, thereby efficiently extracting carriers accumulated in the body region into the source region. That is, the purpose of this embodiment is not to control impact ionization near the drain/body metallurgical junction.

Accordingly, although the same element, argon, as in the above conventional method is ion-implanted, the implantation position is largely different from that in the conventional method, i.e., the implantation position is close to the source/body metallurgical junction and near the interface between the source region and the silicon oxide film for device isolation.

The minority carrier recombination region 11, Fig. 1, in the source region 8, can also be formed to have an island-like planar shape on the silicon oxide film 2. This also applies to the minority carrier recombination region 12.

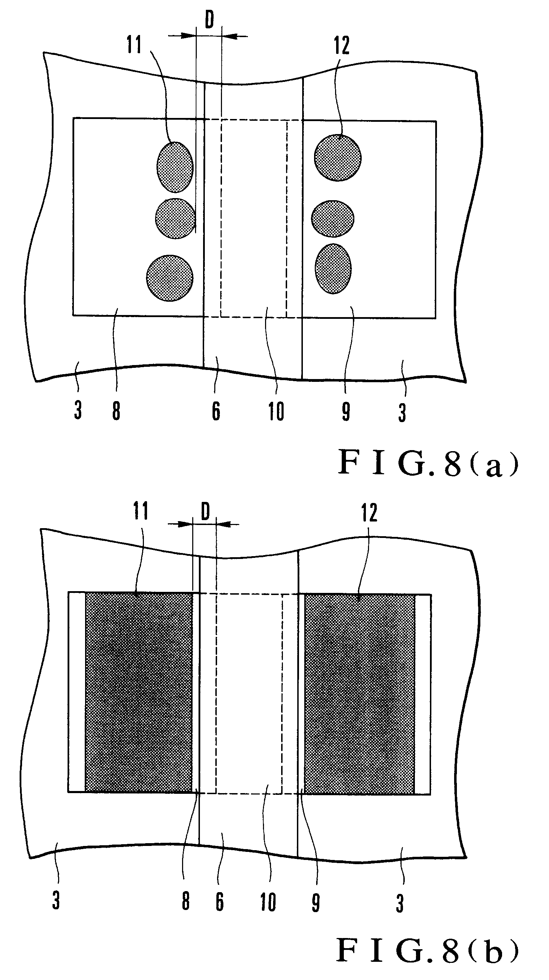

As shown in the plan view of Fig. 8A, it is also possible to form island-like minority carrier recombination regions 11 and 12. In this structure the distance D need only be set as described earlier.

However, the structure illustrated in Fig. 8B is more effective in which the minority carrier recombination region 11 is formed throughout the length which the gate electrode 6 extends in the source region 8. This also holds true for the minority carrier recombination region 12.

As has been described above, the present invention can achieve the startling effects as presented below.

(1) A minority carrier recombination region is formed, in contact with a buried oxide layer, from a position a predetermined distance from a body region, in a source region made from a crystalline semiconductor.

Therefore, even when carriers of a first conductivity type of electron-hole pairs generated near the junction between the body region and a drain region are injected into the source region of a second conductivity type through the body region of the first conductivity type, these carriers of the first conductivity type are forced to vanish in the minority carrier recombination region.

Accordingly, the effective diffusion length of carriers of the first conductivity type in the source region can be greatly decreased compared to a case where no minority carrier recombination region is formed.

(2) Since the effective diffusion length of carriers of the first conductivity type is shortened, it is possible to greatly decrease the number of carriers of the second conductivity type injected from the source region into the body region.

Consequently, a parasitic bipolar transistor is prevented from adversely affecting the intrinsic electrical characteristics of a MOS transistor.

Accordingly, it is possible to realize a device capable of achieving a high packing density and a high operating speed and stably operating when compared to conventional SOI type MOS transistors.

(3) Since a minority carrier recombination region is also formed in the drain region of the second conductivity type, the drain region and the source region have the same structure.

Accordingly, the source and drain regions can freely switch their roles.

(4) The distance from the metallurgical junction between the body and source regions to the minority carrier recombination region and the distance from the metallurgical junction between the body and drain regions to the minority carrier recombination region are determined by a self-aligned method based on ion implantation.

Since this distance corresponds to the diffusion length of carriers explained in item (1) above, a parasitic bipolar transistor can be suppressed with a high controllability.

## Claims

1. A MOS transistor comprising:

    a body region (10) of a first conductivity type formed on a buried insulating film (2) and consisting of a crystalline semiconductor;
    a source region (8) and a drain region (9) of a second conductivity type formed on said buried insulating film (2) so as to sandwich said body region (10) and consisting of a crystalline semiconductor;
    a gate electrode (6) formed on said body region (10) via a gate oxide film (5); and
    a minority carrier recombination region (11) formed, in contact with said buried oxide film (2), in said source region (8) from a position a predetermined distance from said body region (10), and consisting of crystal defects.

2. A MOS transistor according to claim 1, wherein said minority carrier recombination region (11) has at least $1 \times 10^{20}$ $cm^{-3}$ of crystal defects.

3. A MOS transistor according to claim 1, wherein said minority carrier recombination region (11) is separated from said body region (10) by a distance not more than a diffusion length of minority carriers in said source region (8).

4. A MOS transistor according to claim 3, wherein said minority carrier recombination region (11) has at least $1 \times 10^{20}$ $cm^{-3}$ of crystal defects.

5. A method of fabricating a MOS transistor, comprising the steps of:

    forming a body region (10) of a first conductivity type consisting of a crystalline semiconductor on a buried insulating film (2) and forming a source region (8) and a drain region (9) consisting of a crystalline semiconductor on two sides of said body region (10);
    forming a gate oxide film (5) on said body region (10);
    forming a gate electrode (6) on said gate oxide film (5); and
    ion-implanting a rare gas element to form a minority carrier recombination region (11) consisting of crystal defects, in contact with said buried insulating film (2), in said source region (8) from a position a predetermined distance from said body region (10).

6. A method according to claim 5, wherein the rare gas element is argon.

FIG.1

F I G. 2

F I G. 3

ARGON ION
IMPLANTATION

6    7

13    14    3

n+    p    n+

8    11    D    D    12    9    2    1

# F I G. 4

16    15    6    7    17

5

n+    p    n+

3

8    11    13    10    14    12    2    9    1

# F I G. 5

FIG.6

FIG.7

F I G. 8（a）

F I G. 8（b）

FIG.9

F I G. 10

FIG.11